# EUROPÄISCHE PATENTSCHRIFT

(11) **EP 1 921 502 B1**
(45) Veröffentlichungstag und Bekanntmachung des Hinweises auf die Patenterteilung: **02.02.2011**
(21) Anmeldenummer: 06023173.5
(22) Anmeldetag: 08.11.2006
(51) Int. Cl.: G03F 7/20

(54) **Kombiniertes Motion-Control-System**
Combined motion control system
Système de contrôle de mouvements combiné

(43) Veröffentlichungstag der Anmeldung: 14.05.2008
(73) Patentinhaber: Integrated Dynamics Engineering GmbH, 65479 Raunheim (DE)
(72) Erfinder: Heiland, Peter, 65479 Raunheim (DE)
(74) Vertreter: Herden, Andreas F.

(56) Entgegenhaltungen:
- EP-A- 1 126 323
- US-A1- 2005 045 821
- US-B1- 6 999 162

## Beschreibung

### Gebiet der Erfindung

Die Erfindung bezieht sich auf eine Untersuchungs- und Bearbeitungsmaschine und insbesondere auf ein Lithographiegerät. Eine solche Maschine umfasst ein Maschinengestell, eine Untersuchungs- oder Bearbeitungseinrichtung für ein Werkstück, einen Schlitten, der auf dem Maschinengestell gelagert ist und das Werkstück aufnehmen kann, eine Handhabungseinrichtung zum Positionieren des Werkstücks auf dem Schlitten und zum Entfernen von dem Schlitten, eine Reihe von Schwingungsisolatoren zur schwingungsarmen Lagerung des Maschinengestells und einzelne Steuerungseinrichtungen zur Steuerung des Schlittens, der Handhabungseinrichtung und der Schwingungsisolatoren.

### Hintergrund der Erfindung

Die US 6,999,162 beschreibt ein Untersuchungsgerät mit einem Träger, der eine optische Projektionsvorrichtung trägt. Das System umfasst ferner einen Mechanismus zum Bewegen des Objekttisches und einen Rahmen, in welchen eine Kraft, die in Reaktion auf Bewegungen des Objekttisches auftritt, ohne Kontakt zum Träger zum Boden abgeleitet wird. Auf dem Rahmen befindet sich ein Dämpfungselement. Schwingungen sowie die Reaktionskraft werden mittels des Dämpfungslementes in den Boden abgeleitet. Dies macht es auch möglich, eine Kraft zu dämpfen, die vom Boden auf den Träger übertragen wird. Ein Gesamt-Steuerungssystem zur Steuerung einzelner Steuereinrichtungen wird nicht offenbart

Ein aktives Schwingungsisolationssystem für ein Untersuchungsgerät mit geladenen Teilchen ist in der US 2005/0045821 gezeigt. Dieses Gerät umfasst ein Maschinengehäuse bzw. -gestell, in welchem sich eine Transportvorrichtung zur Ablage des zu untersuchenden Werkstücks auf einem Objekttisch befindet. Eine Ladevorrichtung platziert das Werkstück für die Untersuchung. Ferner zeigt die US 2005/0045821 mehrere Steuerungseinrichtungen, z.B. zur Korrektur von Schwingungen des Objekttisches und zur Ausrichtung des Werkstücks. Diese Steuerungseinrichtungen sind zwar einer Hauptsteuerung untergeordnet, jedoch sind sie nicht als Motion-Control-Subsysteme konzipiert.

Ein Lithographiegerät wird in DE 698 29 614 T2 = EP 0 900 412 B1 (Erfinder: Erik R. Loopstra et al.) beschrieben und umfasst einen Rahmen, auf dem sich ein Arm mit Strahlungsquelle und optischem System (=Fokussierungseinheit) befindet. Ferner weist die Maschine eine Positioniervorrichtung auf, auf der sich verschiebbare Substrathalter für das zu bearbeitende Werkstück befinden. Auftretende Schwingungen stören die Betriebsweise von derartigen Lithographiegeräten. Um den Einfluss derartiger Schwingungen auf die Maschine zu minimieren, werden Schwingungsisolationssysteme eingesetzt.

Ein derartiges Schwingungsisolationssystem wird in EP 0 927 380 (Erfinder: Erik R. Loopstra und Peter Heiland) offenbart und beinhaltet vertikal und horizontal wirksame Luftlager.

Solche Schwingungsisolationssysteme können als passive und als aktive Systeme ausgelegt werden. Bei passiven Schwingungsisolationssystemen reagieren die Luftlager lediglich beim Auftreten von Schwingungen, z.B. des Untergrunds, um die schwingungsisoliert gelagerte Maschine von den unerwünschten Schwingungen zu entkoppeln. Bei aktiven Schwingungsisolationssystemen werden zusätzlich Regelungssysteme eingesetzt. Diese messen mittels Sensoren den Schwingungszustand der Maschine, um dann über Aktoren auf die Schwingungsisolatoren Signale zu geben, die den auftretenden Schwingungen entgegenwirken. Mittels derartiger aktiver Schwingungsisolationssysteme gelingt es, die unerwünschten Schwingungen der zu isolierenden Maschine schneller zu dämpfen, als dies beim Einsatz passiver Systeme der Fall ist.

Auch für die anderen beweglichen Teile des Gesamtsystems, insbesondere für den Roboterarm, werden entsprechende Regelungssysteme eingesetzt. Für eine Untersuchungs- oder Bearbeitungsmaschine werden also mehrere voneinander getrennte Regelungssysteme eingesetzt.

Eine grobe Koordination der einzelnen Regelungssysteme wird durch den Einsatz von zusätzlichen Hostsystemen, bestehend aus PCs und Workstations, erreicht. Bei derartigen Systemen sind die einzelnen Regelungssysteme dafür verantwortlich, die Sensorik/Aktorik des jeweils zugeordneten Subsystems in Echtzeit zu bedienen und die Bewegungsaufgaben zu erfüllen, z.B. die Durchführung des Wafertransports. Die Aufgabe der Hostsysteme besteht darin, die Zeitpunkte für diese Bewegungsaufgaben zu bestimmen, sowie Fehlerzustände zu erkennen.

Ein derartiges Hostsystem wird beispielsweise beschrieben in Korean Patent Abstracts, publication number 102000041128A, "Wafer Loading Apparatus". Diese Vorrichtung weist eine Hauptsteuereinrichtung und eine Robotersteuereinrichtung auf. Die Robotsteuereinrichtung steuert in allen drei Raumrichtungen die Bewegungen des Roboters und meldet die Ergebnisse der Steuerung über eine Schnittstelle vom Typ RS232C an die Hauptsteuereinrichtung.

Würde man ein derartiges Hostsystem in Verbindung mit einem aktiven Schwingungsisolationssystem und Regelungssystemen zur Steuerung eines Roboters und anderer beweglicher Teile einer Untersuchungs- und /oder Bearbeitungsmaschine einsetzen, so müsste das Hostsystem in der Lage sein, alle diese Einzelsysteme in Echtzeit zu steuern. D.h. Bewegungen des Roboterarms müssten nicht nur dem Hostsystem in Echtzeit gemeldet werden, sondern das Hostsystem müsste auch zeitgleich Maßnahmen veranlassen, die den durch die Bewegungen des Roboters induzierten, unerwünschten Schwingungen der Gesamtanordnung entgegenwirken. Hierzu müssten, wiederum in Echtzeit, entsprechende Stellsignale an die Aktoren des aktiven Schwingungsisolationssystem gegeben werden. Hierzu sind Hostsysteme nach dem Stand der Technik aber nicht schnell genug.

Nachteilig bei den bislang zum Einsatz kommenden Hostsystemen ist also, dass sie nicht schnell genug sind, um beispielsweise dafür Sorge zu tragen, dass die Auswirkungen einer Bewegung des Roboterarms auf den Schlitten in Echtzeit in ausreichendem Maße gedämpft werden.

### Zusammenfassung der Erfindung

Der Erfindung liegt die Aufgabe zugrunde, bei einer Untersuchungs- und/oder Bearbeitungsmaschine, die ein aktives Schwingungsisolationssystem aufweist, einzelne Motion-Control-Subsysteme zu einem Gesamtsystem zusammenzuführen.

Eine weitere Aufgabe der Erfindung besteht darin, die Abstimmung zwischen einzelnen Motion-Control-Subsystemen deutlich schneller vorzunehmen, als dies nach dem Stand der Technik bislang möglich ist.

Eine noch weitere Aufgabe der Erfindung besteht darin, Schwingungen der Maschine nach Bewegungsvorgängen schneller abzubauen, als dies nach dem Stand der Technik bislang möglich ist.

Die Erfindung wird in Anspruch 1 definiert.

Die Erfindung umfasst ein Untersuchungs- und/oder Bearbeitungsgerät, z.B. ein Lithographiegerät zum Einsatz in der Halbleiterindustrie. Dieses Gerät weist ein Maschinenunterteil, z.B. einen schweren Arbeitstisch, auf, auf dem sich eine Untersuchungs- oder Bearbeitungseinheit befindet. Diese kann einen Arm umfassen, der ein Mikroskop oder eine Belichtungseinheit aufweist. Auf dem Unterteil ist ein bewegbarer Schlitten angebracht, der das zu untersuchende oder zu bearbeitende Substrat, beispielsweise einen Wafer, trägt. Zur Untersuchung oder Bearbeitung des Substrats wird der Schlitten mit dem darauf befindlichen Substrat in die gewünschte Arbeitsposition bewegt, z.B. unterhalb der Untersuchungs- oder Bearbeitungseinheit. Zur Ablage des Substrats auf dem Schlitten oder zur Entfernung des Substrats von dem Schlitten ist ein Roboter mit einem Roboterarm an dem Unterteil der Untersuchungs- oder Bearbeitungsmaschine.

Das Unterteil der Maschine mitsamt allen Aufbauten ist mittels Schwingungsisolatoren gegenüber dem Untergrund schwingungsarm gelagert, um die gesamte Maschine gegen seismische Schwingungen des Untergrunds und andere Störungen zu isolieren.

Derartige unerwünschte Schwingungen werden auch durch Bewegungen des Schlittens und des Roboterarms hervorgerufen. Vor und nach der optischen Untersuchung wird nämlich der Wafer durch den Schlitten, der sich auf dem schwingungsisolierten Unterteil befindet, relativ zur optischen Untersuchungseinheit bewegt. Beim Beschleunigen und Verzögern des Schlittens entstehen masseninduzierte oder andere Störkräfte und Störschwingungen. Derartige Störungen werden auch durch die Bewegungen des Roboterarms beim Abnehmen und Entfernen des Wafers ausgelöst. Solche Störungen sind in der Halbleiterindustrie, beispielsweise wenn Wafer mittels optischer Systeme untersucht werden sollen, sehr unerwünscht.

Zum Ausgleich unerwünschter Schwingungen des Schlittens und des Roboterarms werden jeweils separate Regelungssysteme eingesetzt, deren Aufgabe es ist, die Schwingungen von Schlitten und Roboterarm möglichst schnell zum Abklingen zu bringen.

Bewegungen einzelner Teile des Gesamtsystems übertragen sich aber auch in unerwünschter Weise auf die anderen Maschinenteile. Beispielsweise werden bei einer Bewegung des Roboterarms masseninduzierte Kräfte und somit Störungen auf das Unterteil der Maschine und den Schlitten übertragen. Hinzu kommen durch die Bewegung des Roboterarms ausgelöste Luftdruckschwankungen, die sich auf den Schlitten übertragen.

Solange die einzelnen Regelungssysteme nicht miteinander verbunden sind, ist ein koordiniertes Zusammenspiel der einzelnen Komponenten nicht möglich.

Erfindungsgemäß wird ein derartiges Zusammenspiel dadurch erreicht, dass die bislang getrennten Regelungssysteme einer Gesamt-Steuerungseinrichtung bzw. Motion-Control-System untergeordnet werden. Dieses Motion-Cöntrol-System besteht aus einem einzigen Gerät, das die Regelungssysteme für Maschinenunterteil, Schlitten und Roboterarm über einen echtzeitfähigen Datenbus miteinander verbindet und durch ein weiteres Regelungssystem kontrolliert und koordiniert.

Alle Regelungssubsysteme können die jeweiligen Bewegungsdaten der anderen Subsysteme über den Datenbus erhalten. Auf Basis dieser Daten können auf die Aktoren analoge Kompensationssignale zum Ausgleich unerwünschter Schwingungen gegeben werden.

So kann das Regelungssystem für den Schlitten Informationen in digitaler Form über den Bewegungszustand des Roboterarms erhalten, und auf Basis dieser Daten analoge Steuersignale für die Aktoren und damit auch dämpfende Gegenkräfte auf den Schlitten ausüben lassen.

Geeignete Kompensationssignale auf die Aktoren des Schwingungsisolationssystems führen zu einer Reduzierung der unerwünschten Schwingungen des Gesamtsystems.

Beispielsweise die Bewegungen des Roboterarms sind häufig nach Betrag und Richtung der auftretenden Kräfte vorhersehbar, da es sich beim Ablegen und Entfernen des Wafers um standardisierte Abläufe handelt. Somit sind auch die auftretenden Störungen nach Art und zeitlichem Auftreten vorhersehbar. Daher können die notwendigen Gegenkräfte bzw. die zur Auslösung dieser Gegenkräfte notwendigen Signale vorab bestimmt werden. Dies kann mittels mathematischer Methoden oder experimentell geschehen. Als Ergebnis erhält man Übertragungscharakteristiken bzw. Übertragungsfunktionen. Die derart bestimmten Daten für die Auslösung von Gegenkräften werden im Speicher der Gesamt-Steuerungseinrichtung abgelegt und im Bedarfsfall abgerufen.

In einer alternativen Ausführungsform der Erfindung werden diese Übertragungscharakteristiken in Speichern abgelegt, die sich in den einzelnen Regelungssubsystemen befinden.

Bei den auftretenden Kräften wird unterschieden zwischen solchen, die vorhersehbar und quasi kontinuierlich sind, und solchen, die von eher sprunghafter Natur sind. Die erste Art tritt beispielsweise auf, wenn der Schlitten bewegt wird, die zweite beim Ablegen des Werkstücks auf dem Schlitten.

Bei Kräften der ersten Art wird das die Gegenkraft auslösende Signal durch eine Faltung von Eingangssignal und gespeicherter Übertragungsfunktion erzeugt. Bei Kräften der zweiten Art wird die sprungartige Kraft als Trigger verwendet, um ein Gegenkraftsignal aus einem Speicher abzurufen.

### Kurze Beschreibung der Zeichnungen

Ein Ausführungsbeispiel der Erfindung wird anhand der Zeichnungen beschrieben.

Dabei zeigt:
- Fig. 1: eine schematische Darstellung eines Teils einer schwingungsisoliert gelagerten Untersuchungs- und Bearbeitungsmaschine mit voneinander getrennten Motion-Control-Subsystemen
- Fig. 2: eine schematische Darstellung eines Teils einer Untersuchungs- und Bearbeitungsmaschine mit Ansteuerung von Aktoren eines Schwingungsisolationssystems durch sekundäre Steuerungen
- Fig. 3: eine schematische Darstellung einer Untersuchungs- und Bearbeitungsmaschine mit Gesamt-Steuerungssystem

### Detaillierte Beschreibung

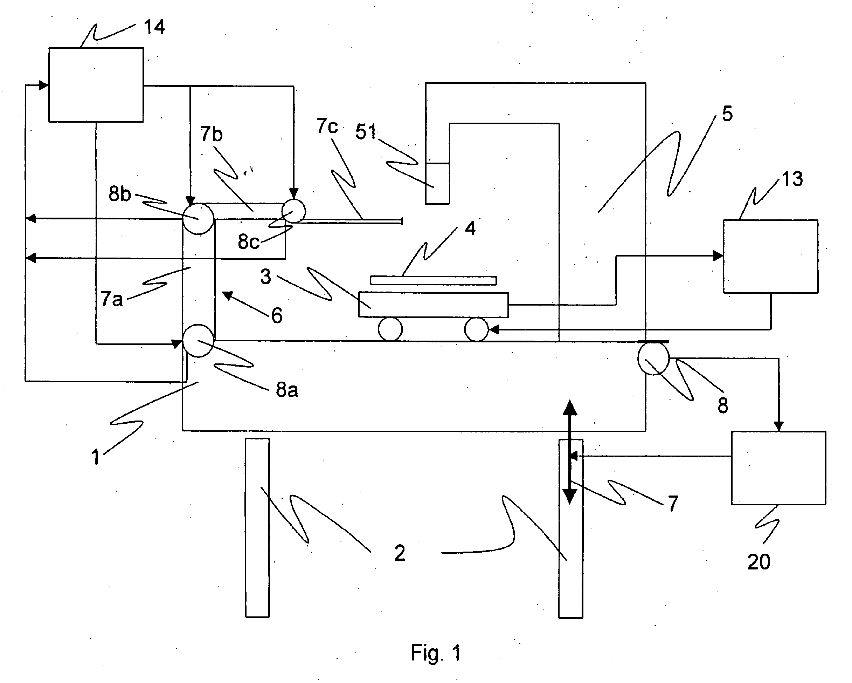

Fig. 1 zeigt in schematischer Darstellung eine Untersuchungs- oder Bearbeitungsmaschine, beispielsweise ein Lithographiegerät zur Belichtung von Wafern in der Halbleiterindustrie. Unterlage dieser Maschine ist ein Maschinengestell 1, das z.B. eine schwere Arbeitsplatte aufweisen kann. Auf dem Maschinengestell 1 befindet sich ein Schlitten 3, der ein Werkstück 4 trägt. Bei dem Werkstück 4 kann es sich z.B. um einen Wafer handeln. Der -Schlitten 3 kann in seiner Position auf dem Maschinengestell 1 verfahren werden, um das Werkstück 4 an verschiedene Bearbeitungspositionen zu bewegen.

Das Maschinengestell trägt ferner zum Einen eine Inspektionsapparatur 5, zum Anderen eine Handhabungseinrichtung 6.

Die Inspektionsapparatur 5 dient der Untersuchung des Werkstücks 4. Sie kann daher ein optisches System 51, z.B. ein Mikroskop, umfassen. Handelt es sich beim Werkstück 4 um einen Wafer, so kann die Inspektionsapparatur 5 auch als Einrichtung zur Belichtung des Wafers 4 ausgebildet sein.

Die Handhabungseinrichtung 6 dient der Positionierung bzw. Entfernung des Werkstücks 4 auf bzw. vom verfahrbaren Schlitten 3. Diese Handhabungseinrichtung 6 kann aus einem Roboter mit drei Armen 7a, 7b, 7c bestehen, die über drei Gelenke 8a, 8b, 8c miteinander und mit dem Maschinengestell 1 beweglich verbunden sind.

Gegenüber dem Untergrund ist das Maschinengestell 1 mittels mehrerer Schwingungsisolatoren 2 schwingungsisoliert gelagert, bei denen es sich z.B. um ein Luft-Federsystem handeln kann. Diese Schwingungsisolatoren 2 isolieren die gesamte auf ihnen gelagerte Anordnung beispielsweise gegenüber seismischen und anderen Schwingungen des Untergrunds.

Ohne weitere zusätzliche Vorrichtungen stellen die Schwingungsisolatoren 2 ein passives Schwingungsisolationssystem dar.

Bei Lithographiegeräten werden üblicherweise aktive Schwingungssysteme eingesetzt. Dies bedeutet eine Ergänzung mit Gruppen von Aktoren 7 und Sensoren 8. Die Aktoren 7 können als Piezoelemente oder als elektromagnetische Motoren ausgebildet sein. Die Sensoren 8 können als Positions-, Geschwindigkeits- oder Beschleunigungssensor ausgebildet sein.

Für jeden Schwingungsisolator 2 ist hierbei zwischen Schwingungsisolator 2 und Maschinengestell 1 ein Aktor 7 vorgesehen, der es ermöglicht, das Maschinengestell 1 vertikal zu bewegen. Die Sensoren 8 sind am Maschinengestell 1 angebracht und detektieren die Vibrationen des Maschinengestells 1 mitsamt aller auf dem Gestell 1 befindlichen Einrichtungen. Stellvertretend für diese Gruppen von Aktoren 7 und Sensoren 8 ist jeweils nur ein Aktor und ein Sensor eingezeichnet.

Zur Steuerung des Schlittens 3 ist eine Steuerungseinrichtung 13 vorgesehen. Soll der Schlitten 3 mit dem auf ihm befindlichen Werkstück 4 in eine neue Arbeitsposition verfahren werden, so sendet die Steuerungseinrichtung 13 entsprechende analoge Steuerbefehle an den Schlitten 3. Der Schlitten 3 sendet seinerseits Signale an die Steuerungseinrichtung 13, die den Bewegungszustand des Schlittens 3 beschreiben. Diese Signale können Positions-, Geschwindigkeits- und/oder Beschleunigungswerte beinhalten.

Zur Steuerung der Handhabungseinrichtung 6 ist eine Steuerungseinrichtung 14 vorgesehen. Soll das Werkstück 4 auf dem Schlitten 3 abgelegt oder vom Schlitten 3 entfernt werden, so sendet die Steuerungseinrichtung 14 entsprechende analoge Stellbefehle an die Gelenke 8a, 8b, 8c bzw. die Arme 7a, 7b, 7c der Handhabungseinrichtung 6, um den diese in die gewünschte Position zu bringen. Die Gelenke 8a, 8b, 8c senden ihrerseits Signale an die Steuerungseinrichtung 14, die den Bewegungszustand der Handhabungseinrichtung 6 beschreiben. Diese Signale können Positions-, Geschwindigkeits- und/oder Beschleunigungswerte sein.

Die Steuerungseinrichtungen 20, 13 und 14 umfassen Regler und stellen daher jeweils ein Motion-Control-Subsystem dar.

Bei der in Fig. 1 dargestellten Konfiguration wird also jedes der Subsysteme Maschinengestell 1, Schlitten 3 und Handhabungseinrichtung 6 separat angesteuert. Jede der Steuerungseinrichtungen 20, 13, 14 hat keine Kenntnis von den jeweils anderen, d.h. nicht ihm selbst zugeordneten Subsystemen. Daher ist es auch nicht möglich, die Auswirkungen der Bewegung eines der Subsysteme auf die anderen zu kompensieren, um die durch diese Bewegung verursachten, unerwünschten Schwingungen dämpfen zu können.

Hierzu müssten die Steuerungseinrichtungen 13 und 14 die Möglichkeit haben, direkt die Aktoren 7 des Schwingungsisolationssystems ansteuern zu können.

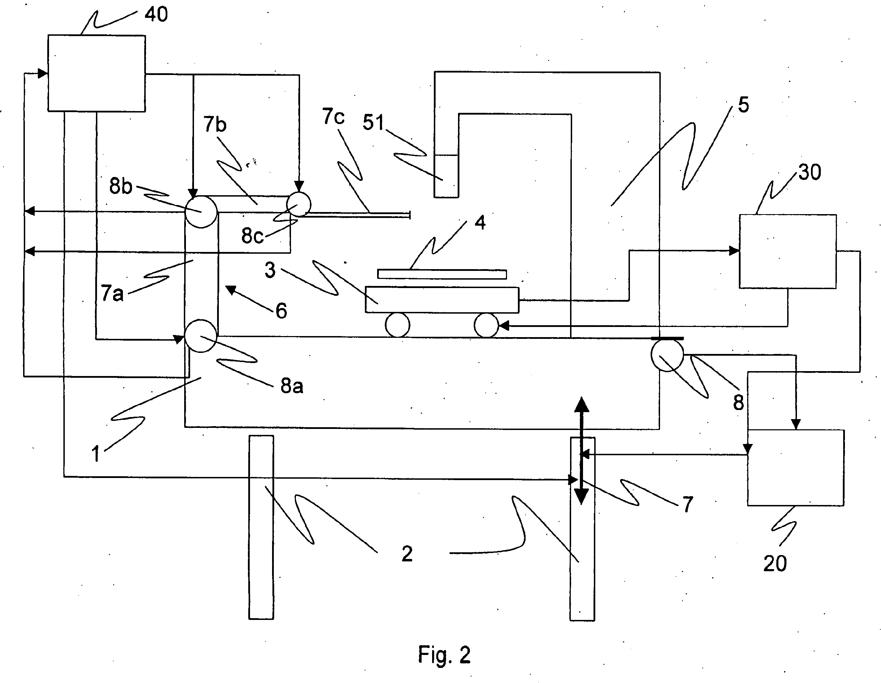

In der im Folgenden beschriebenen Fig. 2 werden die bislang mit den Bezugszeichen 13 und 14 versehenen Steuerungseinrichtungen mit den Bezugszeichen 30 und 40 referenziert, da sie nunmehr im Vergleich zu Fig. 1 erweiterte Aufgaben haben.

Fig. 2 zeigt die Anordnung aus Fig. 1, ergänzt um Verbindungen zwischen den Steuerungseinrichtungen 30 und 40 zu den Aktoren 7 der Schwingungsisolatoren. Diese Verbindungen dienen zum zusätzlichen Ansteuern der Aktoren 7 des Schwingungsisolationssystems.

Wie beschrieben erzeugt die Steuerungseinrichtung 30 die Signale für den Schlitten 3 zur Steuerung der Bewegung desselben, z.B. um das Werkstück 4 in eine neue Arbeitsposition zu bringen. Zum Ausgleich von unerwünschten, vom Schlitten ausgelösten Vibrationen des Gesamtsystems sendet die Steuerungseinrichtung 30, zeitgleich zu den an den Schlitten 3 gesandten Stellsignalen, Steuersignale an die Aktoren 7, um den von den Bewegungen des Schlittens 3 induzierten Vibrationen des Gesamtsystems entgegenzuwirken. Die Steuersignale können als analoge Stellsignale unmittelbar wirken, oder es sind mittelbare Signale, die über die Steuereinrichtung 20 wirken. Da die unerwünschten Auswirkungen der Bewegungen des Schlittens 3 auf das Gesamtsystem auf diese Weise antizipiert werden, wirkt die Steuerungseinrichtung 30 als Feedforwardsystem.

Wie beschrieben empfängt die Steuerungseinrichtung 40 Signale von den drei Gelenken 8a, 8b, 8c der Handhabungseinrichtung 6, die den Bewegungszustand der Handhabungseinrichtung 6 beschreiben. Zur Steuerung der Bewegungen der Handhabungseinrichtung 6 sendet die Steuerungseinrichtungen 40 Stellsignale an die Arme 7a, 7b, 7c bzw. die Gelenke 8a, 8b, 8c. Dies geschieht z.B. dann, wenn das Werkstück 4 auf dem Schlitten 3 abgelegt oder vom Schlitten 3 entfernt werden soll. Treten unerwünschte Schwingungen der Handhabungseinrichtung 6 auf, so werden diese aufgrund der empfangenen Signale festgestellt. Die Steuerungseinrichtung 40 sendet analoge Stellsignale an die Aktoren 7, um entsprechende Gegenbewegungen des Maschinengestells 1 erzeugen, die im Ergebnis den vom Schlitten 3 erzeugten, unerwünschten Schwingungen des Gesamtsystems entgegenwirken. Da die unerwünschten Auswirkungen der Bewegungen der Handhabungseinrichtung 6 auf das Ggesamtsystem auf diese Weise antizipiert werden, stellt auch die Steuerungseinrichtung 40 ein Feedforwardsystem dar.

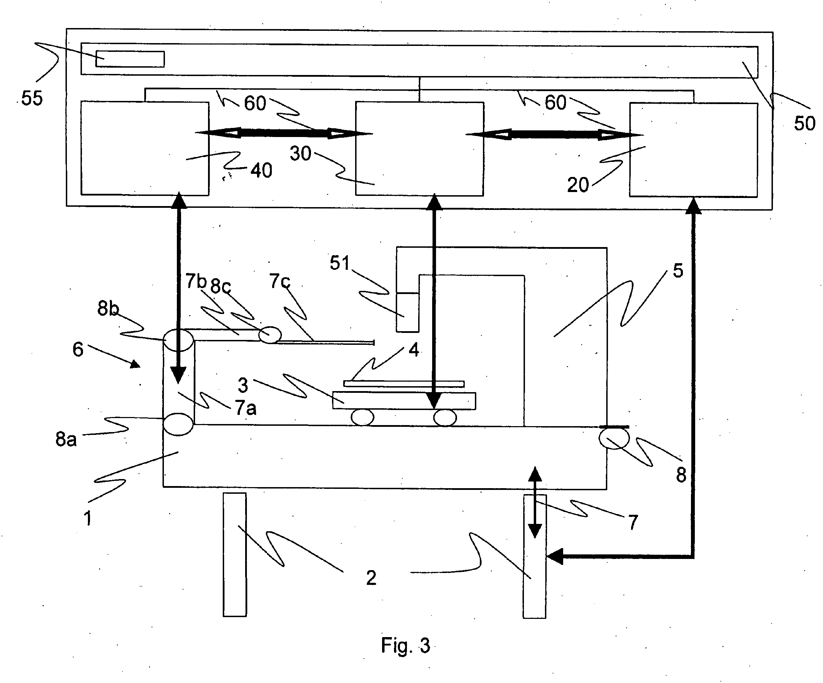

Fig. 3 zeigt die Anordnung aus der Fig. 2 mit den Steuerungseinrichtungen 20, 30, 40 in schematischer Darstellung. Diese Steuerungseinrichtungen 20, 30, 40 sind wiederum mit den Schwingungsisolatoren 2, dem Schlitten 3 und der Handhabungseinrichtung 6 verbunden. Aus Gründen der Übersichtlichkeit sind diese Verbindungen in Fig. 3 lediglich durch jeweils einen Doppelpfeil angedeutet, und nicht durch jeweils zwei Pfeile wie in Fig. 2.

Die Steuerungseinrichtungen 20, 30, 40 sind nunmehr einer Gesamt-Steuerungseinrichtung 50 untergeordnet. Die Verbindung der Steuerungseinrichtungen 20, 30, 40 untereinander und mit der Gesamt-Steuerungseinrichtung 50 ist durch eine Buseinrichtung 60 realisiert, die vorzugsweise digital arbeitet. Die Buseinrichtung 60 dient dem Austausch von Daten zwischen den Steuerungseinrichtungen 20, 30, 40 und der Gesamt-Steuereinrichtung 50. Die Bewegungszustände aller Geräteteile sind aufgrund der Buseinrichtung 60 der Gesamt-Steuerungseinrichtung 50 bekannt, so dass diese eine Koordination der Tätigkeiten der Geräteteile vornehmen kann. Alle Berechnungs- und Steuervorgänge können auf digitaler Ebene vorbereitet werden; analog-digitale Umsetzungen (und umgekehrt) werden so vermieden, was das System ausreichend schnell macht.

Die Gesamt-Steuerungseinrichtung 50 arbeitet als Hostsystem, d.h. ihre Aufgabe besteht in übergeordneter Koordination.

Wird beispielsweise die Handhabungseinrichtung 6 bewegt, so treten masseninduzierte Kräfte auf, die sich auch auf den Schlitten 3 und das optische System 51 auswirken. Ferner treten aufgrund einer Bewegung der Positioniereinrichtung 6 Luftdruckschwankungen auf, die über die Luft ebenfalls auf den Schlitten 3 und das optische System übertragen werden. Umgekehrt beeinflussen Bewegungen des Schlittens 3 die Positioniereinrichtung 6 in unerwünschter Weise.

Die gegenseitige Beeinflussung des Schlittens 3 und der Handhabungseinrichtung 6 wird im Folgenden unter der Annahme beschrieben, dass eine Bewegung der Positioniereinrichtung 6 unerwünschte Schwingungen des Schlittens 3 bewirkt.

Der zeitliche Verlauf der vektoriellen Summe dieser Kräfte, sowohl der masseninduzierten als auch der durch Luftdruckschwankungen verursachten, wird vorab nach Betrag und Richtung erfasst, indem für jeden Freiheitsgrad des Systems der zeitliche Verlauf des Betrages der Kraft gemessen wird. Einen graphische Darstellung dieser Werte des Betrages der Kraft würde eine Krafttrajektorie ergeben.

Diese Kräfte werden von Sensoren am Schlitten 3 bzw. an der Handhabungseinrichtung 6 als Störschwingungen festgestellt. Die Bewegungen der Handhabungseinrichtung 6 wiederholen sich im Rahmen der aufeinander folgenden Untersuchungen oder Bearbeitungen desselben Werkstücks 4 oder mehrerer einzelner Werkstücke 4. Diese Bewegungen der Handhabungseinrichtung 6 und des Werkstücks 4 mit den auftretenden Störschwingungen sind daher nach Art und zeitlichem Auftreten vorhersehbar.

Die Gesamt-Steuerungseinrichtung 50 ist in der Lage Feedforward Signale in einer Speichereinrichtung 55 zu speichern und für die Regeleinrichtungen 20, 30, 40 bereitzustellen.

Soll die Handhabungseinrichtung 6 in der beschriebenen Weise bewegt werden, so liest die Regeleinrichtung 20 zur Kompensation der durch Bewegungen der Handhabungseinrichtung 6 ausgelösten Schwingungen die Signale der Regeleinrichtung 30 aus, und sendet dann geeignete Stellsignale an die Aktoren 7.

Aufgrund der Vorhersehbarkeit der auftretenden Störungen am Schlitten 3 werden von der Regeleinrichtung 20 geeignete Gegenkräfte auf die Aktoren 7 der Schwingungsisolatoren 2 ausgeübt, unter Berücksichtigung der Bewegungssignale aus der Regeleinrichtung 30, so dass im Ergebnis eine Beruhigung des Gesamtsystems, d.h. der Verharrungszustand oder Bewegungszustand vor dem Auftreten der masseninduzierten Kräfte und der durch Luftdruckschwankungen verursachten Kräfte, rascher erzielt wird.

Die Gegenkräfte werden vorab bestimmt. Dies kann mittels zweier Methoden geschehen. Entweder die Gegenkräfte mittels mathematischer Methoden bestimmt, oder vorab experimentell gemessen. Im Ergebnis erhält man eine Übertragungscharakteristik bzw. Übertragungsfunktion. Die so bestimmten Werte für jeden Freiheitsgrad des Systems werden als eine Reihe von Werten, die den zeitlichen Verlauf des Betrags der Kraft darstellen, in einem Speicher 55 der Gesamt-Steuereinrichtung 50 gespeichert und im Bedarfsfall abgerufen.

Hierbei ist zu unterscheiden zwischen inertialen Kräften, die vorhersehbar und quasi kontinuierlich auftreten, und Kräften, die von eher sprungartiger Natur sind. Die erste Art von Kräften tritt beispielsweise auf, wenn der Schlitten 3 bewegt wird, um das Werkstück 4 in eine Arbeitsposition zu bringen. Die zweite Art von Kräften tritt insbesondere beim Ablegen des Werkstücks 4 auf dem Schlitten 3 auf.

Im Falle der quasi kontinuierlichen Kräfte wird das Gegenkraftsignal durch eine Faltung von Eingangssignal und im Speicher 55 gespeicherter Übertragungsfunktion im Speicher 55 erzeugt. Treten sprungartige Kräfte auf, so werden diese als Trigger verwendet, um ein Gegenkraftsignalaus dem Speicher 55 abzurufen.

Auf diese Weise werden unerwünschte Bewegungen von Geräteteilen antizipiert, die durch die gewünschten Bewegungen anderer Geräteteile verursacht werden.

Der beschriebene Ausgleichsmechanismus kann für jede "Kombination" von Geräteteilen vorgesehen werden; beispielsweise werden Bewegungen der Handhabungseinrichtung 6 nicht nur auf den Schlitten 3 übertragen, sondern auch auf das Maschinengestell 1. In jedem dieser Fälle werden letztlich von der Regeleinrichtung 20 geeignete Stellsignale auf die Aktoren 7 gegeben.

## Patentansprüche

1. Untersuchungs- und Bearbeitungsmaschine, insbesondere Lithographiegerät, umfassend
ein Maschinengestell (1),
eine Untersuchungs- oder Bearbeitungseinrichtung (5) für ein Werkstück (4),
ein Schlitten (3), der auf dem Maschinengestell (1) gelagert ist und das Werkstück (4) aufnehmen kann,
eine Handhabungseinrichtung (6) zum Positionieren des Werkstücks (4) auf den Schlitten (3) und zum Entfernen von dem Schlitten (3),
eine Reihe von Schwingungsisolatoren (2), enthaltende Aktoren (7), zur schwingungsarmen Lagerung des Maschinengestells (1), und
einzelne Steuerungseinrichtungen, darunter eine Steuereinrichtung (20) zur Beeinflussung der Schwingungsisolatoren (2), eine Steuerungseinrichtung (30) zur Steuerung des Schlittens (3) und eine Steuerungseinrichtung (40) zur Steuerung der Handhabungseinrichtung (6),
ein Gesamt-Steuerungssystem (50) zur Steuerung der einzelnen Steuereinrichtungen (20, 30, 40),
**dadurch gekennzeichnet, dass** die Steuereinrichtungen (20, 30, 40) als einzelne Motion-Control-Subsysteme des Gesamt-Steuerungssystems (50) ausgebildet sind und untereinander sowie mit dem Gesamt-Steuerungssystem (50) über eine Buseinrichtung (60) in Echtzeit miteinander verbunden sind, um die Betriebsweise des Schlittens (3), der Handhabungseinrichtung (6) und der Schwingungsisolatoren (2) aufeinander abzustimmen.

2. Untersuchungs- und Bearbeitungsmaschine nach Anspruch 1, **dadurch gekennzeichnet, dass**, wenn ein Subsystem übermäßige Schwingungen feststellt, der Start weiterer schwingungserzeugender Vorgänge zurückgestellt wird.

3. Untersuchungs- und Bearbeitungsmaschine nach Anspruch 1 oder 2, **dadurch gekennzeichnet, dass** gleichzeitig mit dem Start eines schwingungserzeugenden Vorgangs durch eine der Steuereinrichtungen (30, 40) zur Steuerung des Schlittens (3) und der Handhabungseinrichtung (6)
ein Feedforwardsignal für die Steuerungseinnchtung (20) zur Beeinflussung der Aktoren (7) bereitgestellt wird, um Schwingungen am Maschinengestell (1) antizipierend entgegenzuwirken.

4. Untersuchungs- und Bearbeitungsmaschine nach Anspruch 3 **dadurch gekennzeichnet, dass** die Steuereinrichtungen (30, 40) zur Steuerung des Schlittens (3) und der Handhabungseinrichtung (6) eine mittelbare Verbindung über die Steuerungseinrichtung (20) zur Beeinflussung der Schwingungsisolatoren (2) zu den Aktoren (7), oder eine direkte Verbindung zu den Aktoren (7) aufweisen.

5. Untersuchungs- und Bearbeitungsmaschine nach Anspruch 3 oder 4 **dadurch gekennzeichnet, dass** das Feedforwardsignal eine Faltung aus einem Bewegungssignal und einer Übertragungsfunktion darstellt.

6. Untersuchungs- und Bearbeitungsmaschine nach einem der vorangehenden Ansprüche, **dadurch gekennzeichnet, dass** die Buseinrichtung (60) ein digitales Bussystem ist.

## Claims

1. Examining and processing machine, in particular a lithography device, comprising a machine frame (1),
a device (5) for examining or processing a workpiece (4),
a carriage (3) which is mounted on the machine frame (1) and can receive the work piece (4),
a handling device (6) for positioning the workpiece (4) onto the carriage (3) and for removing it from the carriage (3),
a series of oscillation isolators (2) for low-oscillation mounting of the machine frame (1), including those which contain actuators (7), and
individual control devices, including a control device (20) for influencing the oscillation isolators (2), a control device (30) for controlling the carriage (3) and a control device (40) for controlling the handling device (6),
an overall control system (50) for controlling the individual control devices (20, 30, 40),
**characterised in that** the control devices (20, 30, 40) are formed as individual motion control subsystems of the overall control system (50) and are connected to each other and to the overall control system (50) in real time via a bus device (60), in order to coordinate the mode of operation of the carriage (3), the handling device (6) and the oscillation isolators (2).

2. Examining and processing machine as claimed in claim 1, **characterised in that** if a subsystem establishes excessive oscillations, the start of further procedures which generate oscillations is postponed.

3. Examining and processing machine as claimed in claim 1 or 2, **characterised in that** at the same time a process which generates oscillations is started by one of the control devices (30, 40) for controlling the carriage (3) and the handling device (6), a feedforward signal is provided for the control device (20) for influencing the actuators (7), in order to counteract oscillations on the machine frame (1) in an anticipatory manner.

4. Examining and processing machine as claimed in claim 3, **characterised in that** the control devices (30, 40) for controlling the carriage (3) and the handling device (6) have an indirect connection to the actuators (7) via the control device (20) for influencing the oscillation isolators (2), or have a direct connection to the actuators (7).

5. Examining and processing machine as claimed in claim 3 or 4, **characterised in that** the feedforward signal represents a convolution of a movement signal and a transfer function.

6. Examining and processing machine as claimed in any one of the preceding claims, **characterised in that** the bus device (60) is a digital bus system.

## Revendications

1. Machine d'examen et d'usinage, en particulier appareil de lithographie, comprenant
un bâti de machine (1),
un dispositif d'examen et d'usinage (5) pour une pièce (4),
un coulisseau (3), qui est monté sur le bâti de machine (1) et peut réceptionner la pièce (4),
un dispositif de manipulation (6) pour le positionnement de la pièce (4) sur le coulisseau (3) et pour l'enlèvement du coulisseau (3),
une série d'isolateurs de vibrations (2) pour le logement antivibratile du bâti de machine (1),
dont ceux qui contiennent des actionneurs (7), et des dispositifs de commande individuels, dont un dispositif de commande (20) pour influencer les isolateurs de vibrations (2), un dispositif de commande (30) pour la commande du coulisseau (3) et un dispositif de commande (40) pour la commande du dispositif de manipulation (6),
un système de commande global (50) pour la commande des dispositifs de commande (20, 30, 40) individuels,
**caractérisée en ce que** les dispositifs de commande (20, 30, 40) sont conçus comme des sous-systèmes individuels de contrôle de mouvement du système de commande global (50) et sont reliés entre eux et au système de commande global (50) au moyen d'un dispositif de bus (60) en temps réel, afin de coordonner le mode de fonctionnement du coulisseau (3), celui du dispositif de manipulation (6) et celui des isolateurs de vibrations (2).

2. Machine d'examen et d'usinage selon la revendication 1, **caractérisée en ce que**, lorsqu'un sous-système constate des vibrations excessives, le démarrage d'autres opérations générant des vibrations est reculé.

3. Machine d'examen et d'usinage selon la revendication 1 ou 2, **caractérisée en ce qu'**un signal d'action directe (feedforward) pour le dispositif de commande (20) destiné à influencer les actionneurs (7) est mis à disposition en même temps que le démarrage d'un processus générant des vibrations par un des dispositifs de commande (30, 40) pour la commande du coulisseau (3) et du dispositif de manipulation (6), afin de s'opposer par anticipation aux vibrations sur le bâti de machine (1).

4. Machine d'examen et d'usinage selon la revendication 3, **caractérisée en ce que** les dispositifs de commande (30, 40) pour la commande du coulisseau (3) et du dispositif de manipulation (6) présentent une liaison indirecte par le dispositif de commande (20) pour influencer les isolateurs de vibrations (2) avec les actionneurs (7) ou une liaison directe avec les actionneurs (7).

5. Machine d'examen et d'usinage selon la revendication 3 ou 4, **caractérisée en ce que** le signal d'action directe représente une convolution faite d'un signal de mouvement et d'une fonction de transmission.

6. Machine d'examen et d'usinage selon l'une quelconque des revendications précédentes, **caractérisée en ce que** le dispositif de bus (60) est un système de bus numérique.
